## Europäisches Patentamt
## European Patent Office
## Office européen des brevets

(11) Veröffentlichungsnummer: **0 246 530 B1**

(12) # EUROPÄISCHE PATENTSCHRIFT

(45) Veröffentlichungstag der Patentschrift: **27.11.91**

(51) Int. Cl.⁵: **H03L 7/08**, G08G 1/09, H04L 7/02

(21) Anmeldenummer: **87106818.5**

(22) Anmeldetag: **11.05.87**

(54) **System zur Decodierung von Datensignalen.**

(30) Priorität: **16.05.86 DE 3616590**

(43) Veröffentlichungstag der Anmeldung:
**25.11.87 Patentblatt 87/48**

(45) Bekanntmachung des Hinweises auf die
Patenterteilung:
**27.11.91 Patentblatt 91/48**

(84) Benannte Vertragsstaaten:
**AT DE FR GB IT SE**

(56) Entgegenhaltungen:
EP-A- 0 089 088          EP-A- 0 115 326
EP-A- 0 121 805          DE-A- 3 407 450
US-A- 3 795 872          US-A- 4 369 515

EUROPEAN BROADCASTING UNION, Tech.
3244-E, März 1984, Seiten 1-60, R. Gressmann, Brüssel, BE; "Specifications of the
radio data system RDS for VHF/FM sound
broadcasting"

(73) Patentinhaber: **Blaupunkt-Werke GmbH**
**Robert-Bosch-Strasse 200**
**W-3200 Hildesheim(DE)**

(72) Erfinder: **Liman, Helmut**
**Meerbrink 19**
**W-3201 Klein Escherde(DE)**

(74) Vertreter: **Eilers, Norbert, Dipl.-Phys.**
**Blaupunkt-Werke GmbH Robert-**
**Bosch-Strasse 200**
**W-3200 Hildesheim(DE)**

## Beschreibung

Das Schutzrecht betrifft ein neues Autoradio mit einem RDS-Signal-Decoder.

Um zusätzlich zu Rundfunksendungen Daten übertragen zu können, ist das sogenannte Radio-Data-System (RDS) bekannt geworden, bei welchem ein Unterträger mit digitalen Signalen moduliert ist. Bei den bisher erfolgten Vorschlägen für ein derartiges System wird ein Unterträger von 57 kHz nach dem Zweiseitenbandverfahren mit einem biphase-codierten Datensignal amplitudenmoduliert, wobei der Träger unterdrückt wird. Durch die Biphase-Codierung erscheinen keine Spektrallinien in der Nähe des Trägers, so daß eine Kompatibilität zum Verkehrsfunksystem gegeben ist.

Zur Demodulation ist im Empfänger ein Synchrondemodulator vorgesehen, welchem außer dem modulierten Signal ein regenerierter Unterträger zugeführt wird. Aus diesem regenerierten Unterträger wird durch Frequenzteilung ein Taktsignal erzeugt, welches der Bitfrequenz der Datensignale entspricht und zur Decodierung der biphasecodierten Signale herangezogen wird.

Insbesondere beim Empfang in Autoradios treten kurzzeitige Störungen auf, die ein Ausrasten des Systemtaktes bewirken können. Derartige Störungen werden insbesondere durch Mehrwegeempfang verursacht.

Der Ausfall des Systemtaktes hat in den nachfolgenden Schaltungen erhebliche Synchronisationsstörungen und Mängel in der Datencodierung zur Folge.

Aus der US-A 4 369 515 ist es bekannt, bei Störungen in von eingehenden Datenströmen abgeleitete Taktsignale im Fall des Überschreitens von Grenzwerten auf ein zweites unabhängiges Signal umzuschalten, um die Daten weiterzuverarbeiten.

In der Spezifikation des Radio-Data-Systems (RDS) ist an sich eine "Bit-Rate-Clock-Recovery" vorgesehen, deren Ausgangsimpulse als Eingangsimpulse der Schaltung nach der genannten US-Patentschrift verwendet werden können.

Die Erfindung löst die Aufgabe, die Störungen im Datenempfang aufzufangen und die Anzahl der unbrauchbaren Bits zu erfassen sowie die Decodierung bei wiedereinsetzendem einwandfreien Empfang sofort fortsetzen zu können oder trotz Störungen Informationen zurückzugewinnen, beispielsweise indem aus mehreren gestörten Datentelegrammen ein vollständiges, fehlerfreies Datentelegramm generiert wird. Sie ist durch die im Anspruch 1 aufgeführten Merkmale gekennzeichnet.

Dabei ist es in vorteilhafter Weise möglich, das zweite Taktsignal aus einer Teilerkette, einem Quarzoszillator und einer Frequenz- oder Phasenregelschleife zu gewinnen. Es sind jedoch auch Weiterbildungen des erfindungsgemäßen Systems mit einem Mikroprozessor und entsprechenden Programmen möglich.

Ein Ausführungsbeispiel der Erfindung ist in der Zeichnung an Hand mehrerer Figuren dargestellt und in der nachfolgenden Beschreibung näher erläutert. Es zeigt:

Fig. 1    ein Blockschaltbild eines erfindungsgemäßen Systems und

Fig. 2    Zeitdiagramme der bei dem System nach Fig. 1 auftretenden Taktsignale.

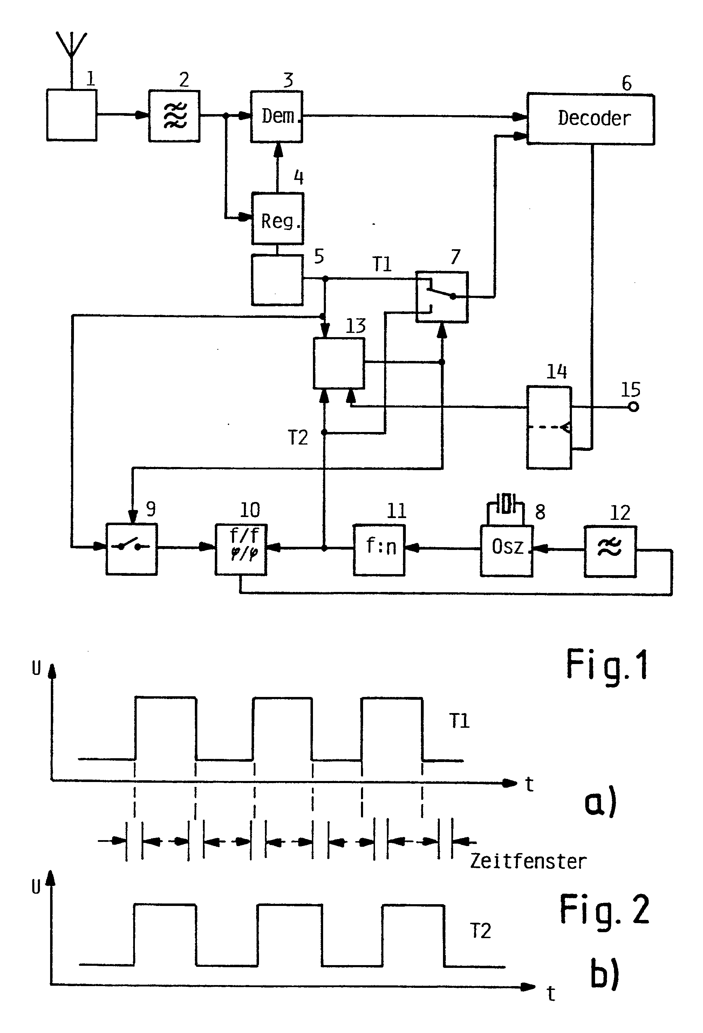

Bei dem in Fig. 1 dargestellten System werden die demodulierten Ausgangssignale eines UKW-Empfängers 1 über einen Bandpaß 2, dessen Mittenfrequenz bei 57 kHz liegt, einem Synchrondemodulator 3 zugeführt. Die Ausgangssignale des Bandpasses 2 werden außerdem einem Trägerregenerator 4 zugeleitet, der einen regenerierten 57 kHz-Träger an den Synchrondemodulator 3 gibt. Die Ausgangssignale des Synchrondemodulators 3 werden in einem an sich bekannten Decoder 6 decodiert. Zur Decodierung der Ausgangssignale des Synchrondemodulators 3 ist ein Bit-Taktsignal erforderlich, welches aus dem regenerierten Unterträger mit Hilfe eines Frequenzteilers 5 gewonnen wird. Während bei dem bekannten Radio-Data-System dieses Bit-Taktsignal - im folgenden erstes Taktsignal genannt - direkt zum Takteingang des Decoders 6 geleitet wird, gelangt das erste Taktsignal bei dem erfindungsgemäßen System über einen Umschalter 7 zum Takteingang des Decoders 6.

Mit dem ersten Taktsignal T1 wird ferner ein Quarzoszillator 8 synchronisiert. Dieses erfolgt dadurch, daß das erste Taktsignal T1 über eine Torschaltung 9 einer Frquenz- und Phasenvergleichsschaltung 10 zugeführt ist. Die Ausgangsspannung des steuerbaren Quarzoszillators 8 wird über einen Frequenzteiler 11 einem weiteren Eingang der Frequenz- und Phasenvergleichsschaltung 10 zugeführt. Je nach Frequenz- und bzw. Phasenablage wird eine Steuerspannung über einen Tiefpaß 12 dem steuerbaren Quarzoszillator zugeführt.

Der steuerbare Quarzoszillator 8 ist bezüglich seiner Frequenz auf die Bit-Taktfrequenz des ausgesendeten Datensignals abgestimmt. Quarzoszillatoren lassen sich nur um eine geringe Frequenzänderung verstimmen, was bei der erfindungsgemäßen Anwendung des steuerbaren Quarzoszillators 8 nicht nachteilig ist, da senderseitig der Bit-Takt mit sehr hoher Genauigkeit erzeugt wird. Stellen sich jedoch plötzliche Frequenz- bzw. Phasenänderungen des ersten Taktsignals T1 ein, so ist dieses ein Zeichen dafür, daß Störungen, insbesondere durch Mehrwegeempfang, vorliegen. In einem solchen Fall wird das Ausgangssignal des Frequenzteilers 11 als zweites Taktsignal T2 über den Umschalter 7 dem Takteingang des Decoders 6 zugeführt.

Zur Steuerung des Umschalters 7 werden das erste Taktsignal T1 und das zweite Taktsignal T2 einem Vergleicher 13 zugeführt. Wird mit Hilfe dieses Vergleichers eine Phasenabweichung zwischen den Taktsignalen festgestellt, welche ein vorgegebenes Maß überschreitet, so wird dem Steuereingang des Umschalters 7 ein Signal zugeführt, welches den Umschalter 7 in die untere Stellung bringt. Ferner wird der Torschaltung 9 ein Signal zugeführt, das die weitere Zuführung des ersten Taktsignals T1 zur Frequenz- und Phasenvergleichsschaltung 10 unterbindet. Dadurch wird verhindert, daß durch das fehlerhafte erste Taktsignal T1 versucht wird, den steuerbaren Quarzoszillator 8 nachzuziehen.

Das Ausgangssignal des Vergleichers 13 kann durch ein von einem Flip-Flop 14 zugeführten Signal gesperrt werden. Dazu wird das Flip-Flop 14 durch einen bei 15 zugeführten Impuls gesetzt. Beim Einschalten des Gerätes und beim Wechsel des Senders wird dem Eingang 15 jeweils ein Impuls zugeführt. Dadurch wird erreicht, daß in einer Anlaufphase nach dem Einschalten bzw. nach einem Senderwechsel der Decoder 6 auf jeden Fall mit dem ersten Taktsignal T1 betrieben wird. Da das zweite Taktsignal T2 über eine hohe Frequenzkonstanz und damit über eine hohe Trägheit verfügt, bleibt es auch während längerer Störungen im Bereich der zulässigen Abweichung von der Sollfrequenz, bedarf jedoch nach dem Einschalten bzw. nach einem Senderwechsel einer längeren Zeit zum Synchronisieren.

Zur Erläuterung der Funktion des Vergleichers 13 sind in Fig. 2 das erste Taktsignal T1 im Diagramm a) und das zweite Taktsignal T2 im Diagramm b) dargestellt. In dem Vergleicher 13 sind Zeitfenster vorgesehen, welche jeweils im Bereich der Flanken des zweiten Taktsignals liegen. Befinden sich die Flanken des ersten Taktsignals T1 ebenfalls in diesen Zeitfenstern, so wird vom Vergleicher 13 ein Signal abgegeben, welches den Umschalter 7 in die obere Stellung bringt, so daß das erste Taktsignal T1 zum Decoder 6 geleitet wird. Dieses ist bei der ersten in Fig. 2 dargestellten Taktperiode der Fall.

Wird jedoch die Frequenz des ersten Taktsignals plötzlich höher, so gelangen die Flanken aus den Zeitfenstern. Das Ausgangssignal des Vergleichers 13 ändert seinen Pegel und bringt damit den Umschalter 7 in die untere Stellung. In Fig. 2 ist bei der zweiten Taktperiode ein Grenzfall erläutert, bei welchem die Rückflanke des zweiten Taktsignals an der Grenze des Zeitfensters liegt, während bei der dritten Taktperiode beide Flanken außerhalb der Zeitfenster liegen und somit ein gestörter Empfang vorliegt.

**Patentansprüche**

1. Autoradio mit einem RDS-Signaldecoder (Radio-Data System), in dem die empfangenen RDS-Signale mittels eines ersten, aus dem RDS-Signal abgeleiteten Taktsignals decodiert werden,
dadurch gekennzeichnet,
daß ein zweites Taktsignal erzeugt wird, dessen Frequenz weitgehend unabhängig von den jeweils herrschenden Empfangsverhältnissen der Taktfrequenz der ausgesendeten RDS-Signale entspricht, und daß bei Auftreten von Störungen in den empfangenen RDS-Signalen das zweite Taktsignal zur Decodierung der RDS-Signale genutzt wird, wenn die Störungen ein vorgegebenes Maß überschreiten und die Phasenlage des ersten Taktsignals mehr als einen vorgegebenen Wert von der Phasenlage des zweiten Taktsignals abweicht.

2. Autoradio nach Anspruch 1,
dadurch gekennzeichnet,
daß für eine vorgegebene Zeit nach dem Einschalten und nach einem Senderwechsel nur das erste Taktsignal genutzt wird.

3. Autoradio nach Anspruch 1,
dadurch gekennzeichnet,
daß zur Erzeugung des zweiten Taktsignals ein steuerbarer Quarzoszillator (8) und eine Frequenz- und Phasenvergleichsschaltung (10) vorgesehen ist.

4. Autoradio nach Anspruch 3,
dadurch gekennzeichnet,
daß einem Decoder (6) die Datensignale und das Ausgangssignal eines Umschalters (7) zugeführt sind, daß einem ersten Eingang des Umschalters (7) das erste Taktsignal und einem zweiten Eingang das zweite Taktsignal zugeführt sind, daß das erste und das zweite Taktsignal ferner einem Vergleicher (13) zugeführt sind, dessen Ausgang mit einem Steuereingang des Umschalters (7) und mit einem Steuereingang einer Torschaltung (9) verbunden ist, welche in der Zuführung des ersten Taktsignals zur Frequenz- und Phasenvergleichsschaltung (10) angeordnet ist.

**Claims**

1. Car radio with an RDS (radio data system) signal decoder, in which the received RDS signals are decoded by means of a first clock signal extracted from the RDS signal, characterised in that a second clock signal is generated, the frequency of which corresponds to the clock frequency of the RDS signals transmitted by and large independently of the respective reception conditions prevailing, and in that when interference occurs in the received RDS signals the second clock signal is used for decoding the RDS signals if the interference exceeds a predetermined amount and the phase position of the first clock signal deviates from the phase position of the second clock signal by more than a predetermined value.

2. Car radio according to Claim 1, characterised in that only the first clock signal is used for a predetermined time after switching on and after changing stations.

3. Car radio according to Claim 1, characterised in that a controllable quartz oscillator (8) and a frequency and phase comparator circuit (10) are provided for generating the second clock signal.

4. Car radio according to Claim 3, characterised in that the data signals and the output signal of a changeover switch (7) are fed to a decoder (6), in that the first clock signal is fed to a first input of the changeover switch (7) and the second clock signal is fed to a second input, in that the first and the second clock signal are furthermore fed to a comparator (13), the output of which is connected to a control input of the changeover switch (7) and to a control input of a gate circuit (9) which is arranged in the supply path of the first clock signal to the frequency and phase comparator circuit (10).

**Revendications**

1. Auto-radio à décodeur de signal (RDS) (radio-Data-Système) dans lequel on décode les signaux (RDS) à l'aide d'un premier signal d'horloge déduit du signal (RDS), caractérisé en ce que :
   - on génère un second signal d'horloge dont la fréquence est très largement indépendante des conditions de réception existant de la fréquence d'horloge du signal (RDS) émis et en ce que en cas de réception de parasites dans les signaux (RDS) reçus, le second signal d'horloge est utilisé pour décoder les signaux (RDS), si les parasites dépassent une limite prédéterminée et que la position de phase du premier signal d'horloge diffère de plus d'une valeur prédéterminée de la position de phase du second signal d'horloge.

2. Auto-radio selon la revendication 1, caractérisé en ce que pendant une durée prédéterminée après le branchement et après un changement d'émetteur, on n' utilise seulement que le premier signal d'horloge.

3. Auto-radio selon la revendication 1, caractérisé en ce que pour générer le second signal d'horloge, on a un oscillateur à quartz commandé (8) et un comparateur de fréquence et de phase (10).

4. Auto-radio selon la revendication 3, caractérisé en ce qu'un décodeur (6) reçoit les signaux de données et le signal de sortie d'un commutateur (7), et en ce qu'une première entrée du commutateur (7) reçoit le premier signal d'horloge et une seconde entrée reçoit le second signal d'horloge, le premier et le second signal d'horloge étant en outre appliqués à un comparateur (13) dont la sortie est reliée à une entrée de commande du commutateur (7) et à une entrée de commande d'une porte (9) qui se trouve dans le chemin de transmission du premier signal d'horloge vers le comparateur de fréquence et de phase (10).

Fig.1

Zeitfenster

Fig.2

a)

b)